# EUROPÄISCHE PATENTANMELDUNG

(11) **EP 1 429 435 A1**
(43) Veröffentlichungstag der Anmeldung: **16.06.2004**
(21) Anmeldenummer: 02028956.7
(22) Anmeldetag: 24.12.2002
(51) Int. Cl.: H01S 5/02, H01S 5/40

(54) **Halbleiterlaservorrichtung und Verfahren zur Herstellung einer derartigen Halbleiterlaservorrichtung**

(30) Priorität: 13.12.2002 DE 10258745
(71) Anmelder: Hentze-Lissotschenko Patentverwaltungs GmbH & Co.KG, 25870 Norderfriedrichskoog (DE)
(72) Erfinder: Lissotschenko, Vitalij, Dr., 58730 Fröndenberg (DE)
(74) Vertreter: Basfeld, Rainer, Dr. Dipl.-Phys.

(57) **Zusammenfassung**

Die vorliegende Erfindung betrifft eine Halbleiterlaservorrichtung umfassend ein Halbleiterlaserelement (1) mit einer Austrittsfläche (2), aus der Laserstrahlung (3) austreten kann, ein Kollimationslinsenmittel (6), das die Divergenz der aus der Austrittsfläche (2) austretenden Laserstrahlung (3) zumindest bezüglich einer ersten, zu der Austrittsrichtung (Z) der Laserstrahlung (3) im Wesentlichen senkrechten Richtung (Y) verringern kann, wobei die Halbleiterlaservorrichtung weiterhin einen Hilfskörper (4) umfasst, der sowohl mit dem Halbleiterlaserelement (1) als auch mit dem Kollimationslinsenmittel (6) fest verbunden ist. Weiterhin betrifft die vorliegende Erfindung einen Halbleiterlaserbaustein aus Halbleiterlaserelement (1), Hilfskörper (4) und Kollimationslinsenmittel (6) sowie ein Verfahren zur Herstellung der Halbleiterlaservorrichtung.

## Beschreibung

Die vorliegende Erfindung betrifft eine Halbleiterlaservorrichtung umfassend ein Halbleiterlaserelement mit einer Austrittsfläche, aus der Laserstrahlung austreten kann, ein Kollimationslinsenmittel, das die Divergenz der aus der Austrittsfläche austretenden Laserstrahlung zumindest bezüglich einer ersten, zu der Austrittsrichtung der Laserstrahlung im Wesentlichen senkrechten Richtung verringern kann. Weiterhin betrifft die vorliegende Erfindung einen Halbleiterlaserbaustein für eine derartige Halbleiterlaservorrichtung sowie ein Verfahren zur Herstellung einer derartigen Halbleiterlaservorrichtung.

Aus der internationalen Patentanmeldung WO 02/082164 A2 sind eine Halbleiterlaservorrichtung und ein Verfahren der vorgenannten Art bekannt. Die darin beschriebene Halbleiterlaservorrichtung umfasst ein Halbleiterlaserelement, das auf einen Kühlkörper aufgelötet sein kann. Bei dem darin beschriebenen Halbleiterlaserelement kann es sich insbesondere um einen sogenannten Laserdiodenbarren handeln, der in einer Richtung beabstandet zueinander angeordnete sich in dieser Richtung längs erstreckende linienförmige Emissionsflächen aufweist. Vor der Austrittsfläche des Halbleiterlaserelementes ist bei dem Stand der Technik ein Kollimationslinsenmittel angeordnet, das insbesondere im Fall des Laserdiodenbarrens als Fast-Axis-Kollimationslinse ausgebildet ist. Diese Fast-Axis-Kollimationslinse verringert die Divergenz der Laserstrahlung in der Richtung senkrecht zu der Richtung, in der linienförmigen Emissionsflächen nebeneinander angeordnet sind. Diese Richtung heißt Fast-Axis. Die auf diese Weise in Richtung der Fast-Axis kollimierte Laserstrahlung kann im Anschluss daran weiter beispielsweise in der dazu senkrechten Richtung, der Slow-Axis, kollimiert werden und beispielsweise auf eine Glasfaser fokussiert werden.

Als problematisch bei derartigen Halbleiterlaserelementen erweist sich die Tatsache, dass als Kühlkörper in der Regel ein großer Kupferblock verwendet wird, als Halbleiterlaserelement aber zumeist eine Diode aus Galliumarsenid. Galliumarsenid und Kupfer haben deutlich unterschiedliche thermische Ausdehnungskoeffizienten. Aus diesem Grund kann die Lötschicht zwischen Kühlkörper und Halbleiterlaserelement nicht sehr dünn und auch nicht bei sehr hohen Temperaturen ausgeführt werden, weil in beiden Fällen so hohe thermisch bedingte Spannung auftreten würden, dass das Halbleiterlaserelement Schaden nehmen könnte. Die Lötschicht hat somit üblicherweise eine Dicke von etwa 5 µm und wird bei Temperaturen zwischen 180 °C und 200 °C hergestellt. Es handelt sich also um eine vergleichsweise weiche Lötschicht. Insbesondere aufgrund dieser weichen Lötschicht aber auch beispielsweise bei alternativen Befestigungsmethoden wie dem Anschrauben des Halbleiterlaserelementes auf den Kühlkörper, kann es zu Verbiegungen des Halbleiterlaserelementes über die Länge seiner Emissionsflächen beziehungsweise seiner Austrittsfläche kommen. Diese Verbiegung nennt man im Allgemeinen "Smile"-Verzerrung. Eine Laserstrahlung mit "Smile"-Verzerrung, die durch eine Fast-Axis-Kollimationslinse hindurchtritt wird beispielsweise in einem mittleren Bereich, in dem die Austrittsfläche gegenüber den äußeren Bereichen nach unten verschoben ist, in diesem mittleren Bereich nach oben abgelenkt. Auf diese Weise ergibt sich bei dem Stand der Technik eine aus dem Kollimationslinsenmittel austretende Laserstrahlung, die in der Richtung der Fast-Axis auseinander läuft und somit schwer weiter zu verarbeiten ist. Dies führt bei den aus dem Stand der Technik bekannten Halbleiterlaservorrichtungen zu großen Intensitätsverlusten der aus der Halbleiterlaservorrichtung austretenden Laserstrahlung. In dem vorgenannten Stand der Technik wird mit vergleichsweise aufwendigen Mitteln versucht, diese "Smile"-Verzerrung zu kompensieren. Dazu werden insbesondere viele verschiedene nebeneinander angeordnete zueinander gekippte Linsenmittel verwendet.

Das der vorliegenden Erfindung zugrunde liegende Problem ist die Schaffung einer Halbleiterlaservorrichtung der eingangs genannten Art, bei der mit einfachen Mitteln eine Vermeidung derartiger Verzerrungen erzielt werden kann. Weiterhin soll ein Halbleiterlaserbaustein für eine derartige Halbeleiterlaservorrichtung geschaffen werden. Weiterhin soll ein Verfahren zur Herstellung einer derartigen Halbleiterlaservorrichtung angegeben werden.

Dies wird erfindungsgemäß hinsichtlich der Halbleiterlaservorrichtung durch die Merkmale des Anspruchs 1, hinsichtlich des Halbleiterlaserbausteins durch die Merkmale des Anspruchs 13 und hinsichtlich des Verfahrens durch die Merkmale des Anspruchs 14 erreicht.

Gemäß Anspruch 1 ist vorgegeben, dass die Halbleiterlaservorrichtung weiterhin einen Hilfskörper umfasst, der sowohl mit dem Halbleiterlaserelement als auch mit dem Kollimationslinsenmittel fest verbunden ist. Durch die dadurch erzielte feste Verbindung zwischen Kollimationslinsenmittel und Halbleiterlaserelement wird erreicht, dass bei Verbiegung des Halbleiterlaserelementes gleichzeitig auch das Kollimationslinsenmittel mit verbogen wird. Wenn sich somit die beispielsweise langgestreckte linienförmige Austrittsfläche für Laserstrahlung in der Mitte nach unten durchbiegt, wird das Kollimationslinsenmittel etwa in gleichem Maße ebenfalls nach unten durchgebogen. Auf diese Weise kommt es nicht zu den typischen aus dem Stand der Technik bekannten Problemen aufgrund von durch ein nicht verbogenes Kollimationslinsenmittel hindurchgetretene "Smile" verzerrte Laserstrahlung.

Aufgrund des Mitverbiegen des Kollimationslinsenmittels wird erreicht, dass die aus dem Kollimationslinsenmittel austretende Laserstrahlung nicht mehr in Richtung der Fast-Axis auseinander läuft. Dadurch kann die Laserstrahlung wesentlich besser in Slow-Axis-Richtung kollimiert und weiter fokussiert werden. Dadurch kann mit der erfindungsgemäßen Halbleiterlaservorrichtung eine wesentlich größere Leistungsdichte erzielt werden.

Erfindungsgemäß kann vorgesehen sein, dass die feste Verbindung zwischen Halbleiterlaserelement und Hilfskörper als erste Lötschicht ausgeführt ist. Weiterhin kann die feste Verbindung zwischen Hilfskörper und Kollimationslinsenmittel als zweite Lötschicht ausgeführt sein. Diese Lötschichten können eine Dicke zwischen 0,05 µm und 1 µm, insbesondere eine Dicke zwischen 0,1 µm und 0,5 µm aufweisen. Durch derartig dünne und feste Lötschichten können sehr feste Verbindungen zwischen dem Halbleiterlaserelement und dem Hilfskörper sowie dem Hilfskörper und dem Kollimationslinsenmittel hergestellt werden. Auf diese Weise kann gewährleistet werden, dass sich das Kollimationslinsenmittel bei Verbiegung des Halbleiterlaserelementes etwa im gleichen Maße mit verbiegt.

Gemäß einer bevorzugten Ausführungsform der vorliegenden Erfindung kann vorgesehen sein, dass das Halbleiterlaserelement und der Hilfskörper aus im Wesentlichen dem gleichen Material bestehen. Das Halbleiterlaserelement und der Hilfskörper können beispielsweise aus Galliumarsenid bestehen. Durch die Wahl des gleichen Materials für das Halbleiterlaserelement und den Hilfskörper wird sichergestellt, dass bei einer Herstellung der vorgenannten Lötschicht keine Probleme aufgrund unterschiedlicher thermischer Ausdehnungskoeffizienten auftreten können. Bei etwa gleichen thermischen Ausdehnungskoeffizienten kann somit eine sehr dünne, sehr feste Lötschicht geschaffen werden.

Erfindungsgemäß kann vorgesehen sein, dass das Kollimationslinsenmittel zusammen mit einem Träger einstückig in einem Substrat, insbesondere einem Glassubstrat ausgebildet ist. Hierbei kann der Träger fest mit dem Hilfskörper verbunden sein, insbesondere über die zweite Lötschicht. Vorteilhafterweise bestehen dabei das Kollimationslinsenmittel und/oder der Träger aus einem Material, das im Wesentlichen den gleichen thermischen Ausdehnungskoeffizienten aufweist wie der Hilfskörper. Dabei können das Kollimationslinsenmittel und/oder der Träger aus einem Material bestehen, das im Wesentlichen den gleichen thermischen Ausdehnungskoeffizienten aufweist wie Galliumarsenid. Somit treten auch bei der Herstellung der zweiten Lötschicht zwischen Träger und Hilfskörper keine Probleme aufgrund unterschiedlicher thermischer Ausdehnungskoeffizienten auf. Beispielsweise kann für das Substrat, in dem der Träger und das Kollimationslinsenmittel ausgebildet sind, ein Glas verwendet werden, das den gleichen thermischen Ausdehnungskoeffizienten aufweist wie Galliumarsenid.

Es besteht erfindungsgemäß weiterhin die Möglichkeit, dass die Halbleiterlaservorrichtung einen Kühlkörper umfasst, der mit dem Halbleiterlaserelement verbunden ist. Der Kühlköper kann mit dem Halbleiterlaserelement über eine dritte Lötschicht verbunden sein, wobei diese dritte Lötschicht eine Dicke von insbesondere etwa 5 µm aufweisen kann. Diese dritte Lötschicht kann erfindungsgemäß also durchaus ähnlich gestaltet sein wie die Lötschichten aus dem Stand der Technik. Da bei der vorliegenden Erfindung das Kollimationslinsenmittel für die Fast-Axis nicht mehr direkt mit dem Kühlkörper verbunden ist, wie dies teilweise im Stand der Technik praktiziert wird, sondern über die erste und die zweite Lötschicht fest mit dem Halbleiterlaserelement verbunden ist, entstehen auch durch die vorgenannte dicke weiche Lötschicht zwischen Halbleiterlaserelement und Kühlkörper keine Nachteile.

Gemäß Anspruch 13 umfasst ein erfindungsgemäßer Halbleiterlaserbaustein ein Halbleiterlaserelement, ein Kollimationslinsenmittel und einen Hilfskörper, wobei diese sowie deren Verbindung miteinander die vorgenannten Merkmale einer der Ansprüche 1 bis 10 aufweisen. Ein derartiger Halbleiterbaustein kann beispielsweise auch separat gehandelt werden und von Benutzern vor Ort mit einem Kühlkörper verbunden werden. Der Halbleiterlaserbaustein stellt den Kern einer Halbleiterlaservorrichtung dar und kann eine in Fast-Axis-Richtung gut kollimierte intensive Laserstrahlung zur Verfügung stellen.

Gemäß Anspruch 14 ist das erfindungsgemäße Verfahren dadurch gekennzeichnet, dass das Halbleiterlaserelement, der Hilfskörper und das Kollimationslinsenmittel fest zu einem Halbleiterbaustein gemäß Anspruch 13 verbunden werden. Insbesondere können dabei das Halbleiterlaserelement mit dem Hilfskörper und/oder der Hilfskörper mit dem Kollimationslinsenmittel verlötet werden.

Gemäß einer bevorzugten Ausführungsform der vorliegenden Erfindung findet das Verlöten von Halbleiterlaserelement und Hilfskörper und/oder Hilfskörper und Kollimationslinsenmittel bei einer Temperatur von etwa 400 °C statt. Bei derartigen Temperaturen lassen sich sehr feste und trotzdem dünne Lötschichten erzielen. Die vergleichsweise hohen Temperaturen von 400 °C sind trotzdem unproblematisch für die verwendeten Materialien, da insbesondere vorgesehen ist, die thermischen Ausdehnungskoeffizienten der verwendeten Materialien aneinander anzupassen.

Vorteilhafterweise ist vorgesehen, dass in einem weiteren Schritt des Verfahrens der Halbleiterlaserbaustein mit einem Kühlkörper verbunden wird. Hierbei kann der Halbleiterlaserbaustein mit dem Kühlkörper verlötet werden, insbesondere bei einer Temperatur zwischen 180 °C und 200 °C. Wie bereits erwähnt kann dies auch unproblematisch bei dem Endkunden der erfindungsgemäßen Halbleiterlaservorrichtung beziehungsweise des erfindungsgemäßen Halbleiterlaserbausteins erfolgen.

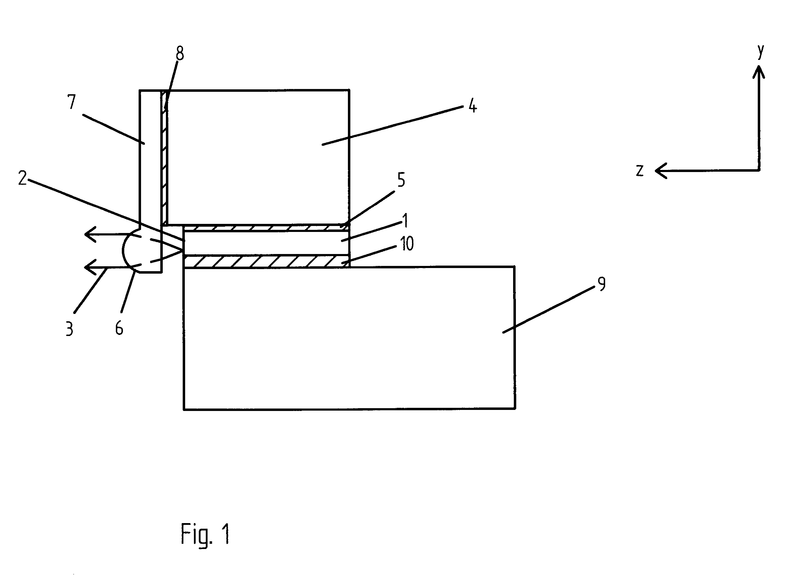

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigt
- Fig. 1: eine schematische Seitenansicht einer erfindungsgemäßen Halbleiterlaservorrichtung.

Aus Fig. 1 ist ersichtlich, dass eine erfindungsgemäße Halbleiterlaservorrichtung ein Halbleiterlaserelement 1 mit einer Austrittsfläche 2 umfasst, aus der Laserstrahlung 3 austreten kann. Das Halbleiterlaserelement 1 kann insbesondere als Halbleiterlaserbarren ausgeführt sein. Ein derartiger Halbleiterlaserbarren umfasst in X-Richtung (siehe das eingezeichnete Koordinatensystem) eine ganze Reihe von beabstandet nebeneinander angeordneten linienförmigen Emissionsflächen, wobei sich diese Emissionsflächen ebenfalls im Wesentlichen in X-Richtung erstrecken. In der dazu senkrechten Y-Richtung weisen die Emissionsflächen eine sehr geringe Ausdehnung auf. Aus diesem Grund weist die Laserstrahlung 3 in Y-Richtung eine vergleichsweise hohe Divergenz, die sogenannte Fast-Axis-Divergenz auf.

Die erfindungsgemäße Halbleiterlaservorrichtung umfasst weiterhin einen Hilfskörper 4, der in dem abgebildeten Ausführungsbeispiel auf der Oberseite des Halbleiterlaserelementes 1 angebracht ist, insbesondere fest mit diesem verbunden ist. Die feste Verbindung zwischen Halbleiterlaserelement 1 und Hilfskörper 4 kann durch eine erste Lötschicht 5 erzielt werden. Diese erste Lötschicht kann vergleichsweise dünn sein, insbesondere zwischen 0,1 µm und 0,5 µm dick sein. Die erste Lötschicht kann durch Löten bei einer Temperatur von etwa 400 °C ausgebildet werden.

Das Halbleiterlaserelement 1 und der Hilfskörper 4 können aus dem gleichen Material bestehen. Beispielsweise können sowohl das Halbleiterlaserelement 1 als auch der Hilfskörper 4 aus Galliumarsenid bestehen. Aufgrund der Tatsache, dass sowohl Halbleiterlaserelement 1 als auch Hilfskörper 4 aus dem gleichen Material bestehen, treten keine thermischen Spannungen auf bei dem Erwärmen oder dem Abkühlen der beiden über die erste Lötschicht 5 miteinander verbundenen Bauteile. Aus diesem Grund kann die Verbindung zwischen Halbleiterlaserelement 1 und Hilfskörper 4 sehr fest gewählt sein, insbesondere als die vorgenannte sehr dünne und feste erste Lötschicht 5.

Wie aus Fig. 1 ersichtlich ist umfasst die Halbleiterlaservorrichtung weiterhin ein Kollimationslinsenmittel 6, das eine einstückige Einheit mit einem Träger 7 bildet, der fest mit dem Hilfskörper 4 verbunden ist. Das Kollimationslinsenmittel 6 kann dabei als Fast-Axis-Kollimationslinse ausgebildet sein. Insbesondere kann das Kollimationslinsenmittel 6 eine Zylinderlinsengeometrie mit Zylinderachse in X-Richtung aufweisen. Das Kollimationslinsenmittel 6 und der Träger 7 sind insbesondere in einem einstückigen Glassubstrat ausgebildet.

Wie aus Fig. 1 ersichtlich ist, ragt der Hilfskörper 4 in Z-Richtung ein Stück weit über die Austrittsfläche 2 hinaus. Die in Z-Richtung stirnseitige Fläche des Hilfskörpers 4 ist parallel zu der Austrittsfläche 2 und gegenüber dieser ein Stück weit in positiver Z-Richtung versetzt. Mit dieser Fläche des Hilfskörpers 4 ist der Träger 7 beispielsweise mittels einer zweiten Lötschicht 8 fest verbunden. Auch bei dieser zweiten Lötschicht kann es sich beispielsweise um eine bei Temperaturen bei etwa 400 °C erstelle Lötschicht mit einer Dicke von beispielsweise 0,1 µm bis 0,5 µm handeln.

Es besteht erfindungsgemäß die Möglichkeit, dass die Kollimationslinsenmittel 6 mit dem integrierten Träger 7 aus einem Glas gefertigt sind, das den gleichen thermischen Ausdehnungskoeffizienten aufweist wie der Hilfskörper 4. Insbesondere kann somit das Glas, aus dem das Kollimationslinsenmittel 6 und der Träger 7 gebildet sind, den gleichen thermischen Ausdehnungskoeffizienten aufweisen wie Galliumarsenid.

In Fig. 1 ist weiterhin ein Kühlkörper 9 eingezeichnet, der über eine dritten Lötschicht 10 mit dem Halbleiterlaserelement 1 verbunden ist. Der Kühlkörper 9 kann beispielsweise aus Kupfer gefertigt sein und dient wie dies auch aus dem Stand der Technik bekannt ist zur Kühlung der aktiven Schicht des Halbleiterlaserelementes 1. Diese aktive Schicht ist, wie dies aus Fig. 1 ersichtlich ist, vergleichsweise weit unten in dem Halbleiterlaserelement 1 angeordnet, so dass sie durch den Kühlkörper 9 effektiv gekühlt werden kann. Die dritte Lötschicht 10 zwischen Kühlkörper 9 und Halbleiterlaserelement 1 ist wie dies auch aus dem Stand der Technik bekannt ist als vergleichsweise weiche Lötschicht ausgebildet. Derartige weiche Lötschichten werden etwa bei Temperaturen zwischen 180 °C und 200 °C gelötet. Weiterhin ist die dritte Lötschicht zwischen Kühlkörper 9 und Halbleiterlaserelement 1 vergleichsweise dick, beispielsweise etwa 5 µm dick.

In Fig. 1 ist weiterhin eingezeichnet, dass die von dem Halbleiterlaserelement 1 ausgehende Laserstrahlung 3 von dem Kollimationslinsenmittel 6 bezüglich der Y-Richtung kollimiert wird. Es besteht durchaus die Möglichkeit, in positiver Z-Richtung an die erfindungsgemäße Halbleiterlaservorrichtung weitere Kollimationsmittel zur Kollimierung bezüglich der X-Achse anzuordnen, insbesondere sogenannte Slow-Axis-Kollimationslinsen.

Aufgrund der festen Verbindung zwischen Halbleiterlaserelement 1 und Kollimationsmittel 6 wird bei Temperaturveränderungen und sich dadurch beispielsweise ergebenden Verbiegungen des Halbleiterlaserelementes 1 das Kollimationslinsenmittel 6 im gleichen Maße mit verbogen, so dass eventuelle Verzerrungen der Laserstrahlungen, wie die bekannte "Smile"-Verzerrung nicht auftreten.

Bei dem erfindungsgemäßen Verfahren zur Herstellung einer erfindungsgemäßen Halbleiterlaservorrichtung wird zuerst ein Halbleiterlaserbaustein geschaffen, der aus dem Halbleiterlaserelement 1, dem Hilfskörper 4 und dem Kollimationslinsenmittel 6 mit integriertem Träger 7 besteht. Dieser Halbleiterlaserbaustein kann beispielsweise dadurch erstellt werden, dass in einem ersten Arbeitsgang der Hilfskörper 4 auf das Halbleiterlaserelement 1 aufgelötet wird. In einem zweiten Arbeitsgang wird der Träger 7 an dem Hilfskörper 4 angelötet, wobei beispielsweise bei eingeschaltetem Halbleiterlaserelement 1 die genaue Positionierung des Kollimationslinsenmittels 6 vor dem Halbleiterlaserelement 1 anhand der aus dem Kollimationslinsenmittel 6 austretenden Laserstrahlung 3 überprüft werden kann.

Der auf diese Weise gefertigte Halbleiterlaserbaustein kann in einem weiteren Verfahrensschritt auf den Kühlkörper 9 aufgelötet werden. Der Halbleiterlaserbaustein kann insbesondere auch separat gehandelt werden.

## Patentansprüche

1. Halbleiterlaservorrichtung umfassend
- ein Halbleiterlaserelement (1) mit einer Austrittsfläche (2), aus der Laserstrahlung (3) austreten kann;
- ein Kollimationslinsenmittel (6), das die Divergenz der aus der Austrittsfläche (2) austretenden Laserstrahlung (3) zumindest bezüglich einer ersten, zu der Austrittsrichtung (Z) der Laserstrahlung (3) im Wesentlichen senkrechten Richtung (Y) verringern kann;
**dadurch gekennzeichnet, dass**
- die Halbleiterlaservorrichtung weiterhin einen Hilfskörper (4) umfasst, der sowohl mit dem Halbleiterlaserelement (1) als auch mit dem Kollimationslinsenmittel (6) fest verbunden ist.

2. Halbleiterlaservorrichtung nach Anspruch 1, **dadurch gekennzeichnet, dass** die feste Verbindung zwischen Halbleiterlaserelement (1) und Hilfskörper (4) als erste Lötschicht (5) ausgeführt ist.

3. Halbleiterlaservorrichtung nach einem der Ansprüche 1 oder 2, **dadurch gekennzeichnet, dass** die feste Verbindung zwischen Hilfskörper (4) und Kollimationslinsenmittel (6) als zweite Lötschicht (8) ausgeführt ist.

4. Halbleiterlaservorrichtung nach einem der Ansprüche 2 oder 3, **dadurch gekennzeichnet, dass** die mindestens eine zu der festen Verbindung beitragende Lötschicht (5, 8) eine Dicke zwischen 0,05 µm und 1 µm, insbesondere eine Dicke zwischen 0,1 µm und 0,5 µm aufweist.

5. Halbleiterlaservorrichtung nach einem der Ansprüche 1 bis 4, **dadurch gekennzeichnet, dass** das Halbleiterlaserelement (1) und der Hilfskörper (4) aus im Wesentlichen dem gleichen Material bestehen.

6. Halbleiterlaservorrichtung nach Anspruch 5, **dadurch gekennzeichnet, dass** das Halbleiterlaserelement (1) und der Hilfskörper (4) aus Galliumarsenid bestehen.

7. Halbleiterlaservorrichtung nach einem der Ansprüche 1 bis 6, **dadurch gekennzeichnet, dass** das Kollimationslinsenmittel (6) zusammen mit einem Träger (7) einstückig in einem Substrat, insbesondere in einem Glassubstrat ausgebildet ist.

8. Halbleiterlaservorrichtung nach Anspruch 7, **dadurch gekennzeichnet, dass** der Träger (7) fest mit dem Hilfskörper (4) verbunden ist, insbesondere über die zweite Lötschicht (8).

9. Halbleiterlaservorrichtung nach einem der Ansprüche 1 bis 8, **dadurch gekennzeichnet, dass** das Kollimationslinsenmittel (6) und/oder der Träger (7) aus einem Material bestehen, das im Wesentlichen den gleichen thermischen Ausdehnungskoeffizienten aufweist wie der Hilfskörper (4).

10. Halbleiterlaservorrichtung nach Anspruch 9, **dadurch gekennzeichnet, dass** das Kollimationslinsenmittel (6) und/oder der Träger (7) aus einem Material bestehen, das im Wesentlichen den gleichen thermischen Ausdehnungskoeffizienten aufweist wie Galliumarsenid.

11. Halbleiterlaservorrichtung nach einem der Ansprüche 1 bis 10, **dadurch gekennzeichnet, dass** die Halbleiterlaservorrichtung weiterhin einen Kühlkörper (9) umfasst, der mit dem Halbleiterlaserelement (1) verbunden ist.

12. Halbleiterlaservorrichtung nach Anspruch 11, **dadurch gekennzeichnet, dass** der Kühlkörper (9) mit dem Halbleiterlaserelement (1) über eine dritte Lötschicht (10) verbunden ist, wobei diese dritte Lötschicht (10) eine Dicke von insbesondere etwa 5 µm aufweisen kann.

13. Halbleiterlaserbaustein für eine Halbleiterlaservorrichtung nach einem der Ansprüche 1 bis 12, umfassend ein Halbleiterlaserelement (1), ein Kollimationslinsenmittel (6) und einen Hilfskörper (4) mit den das Halbleiterlaserelement (1), das Kollimationslinsenmittel (6) und den Hilfskörper (4) sowie deren Verbindung miteinander betreffenden Merkmalen einer der Ansprüche 1 bis 10.

14. Verfahren zur Herstellung einer Halbleiterlaservorrichtung nach einem der Ansprüche 1 bis 12, **gekennzeichnet durch** folgende Verfahrensschritte:
- das Halbleiterlaserelement (1), der Hilfskörper (4) und das Kollimationslinsenmittel (6) werden fest zu einem Halbleiterlaserbaustein gemäß Anspruch 13 verbunden.

15. Verfahren nach Anspruch 14, **dadurch gekennzeichnet, dass** das Halbleiterlaserelement (1) mit dem Hilfskörper (4) und/oder der Hilfskörper (4) mit dem Kollimationslinsenmittel (6) verlötet werden.

16. Verfahren nach Anspruch 15, **dadurch gekennzeichnet, dass** das Verlöten von Halbleiterlaserelement (1) und Hilfskörper (4) und/oder Hilfskörper (4) und Kollimationslinsenmittel (6) bei einer Temperatur von etwa 400 °C stattfindet.

17. Verfahren nach einem der Ansprüche 14 bis 16, **dadurch gekennzeichnet, dass** in einem weiteren Schritt der Halbleiterlaserbaustein gemäß Anspruch 13 mit einem Kühlkörper (9) verbunden wird.

18. Verfahren nach Anspruch 17, **dadurch gekennzeichnet, dass** der Halbleiterlaserbaustein mit dem Kühlkörper (9) verlötet wird, insbesondere bei einer Temperatur zwischen 180 °C und 200 °C.
